# EUROPEAN PATENT APPLICATION

(11) **EP 4 787 058 A1**
(43) Date of publication of application: **05.08.2026**
(21) Application number: 26154693.1
(22) Date of filing: 28.01.2026
(51) Int. Cl.: G02B 27/09, G01N 21/25, G01N 21/64, G03B 21/20

(54) **OPTICAL ELEMENT FOR BEAM SHAPING**

(30) Priority: 30.01.2025 LU 103530
(71) Applicant: Stratec SE, 75217 Birkenfeld (DE)
(72) Inventor: Quitschke, Lisa-Marie, 75217 Birkenfeld (DE); Trump, Martin, 75217 Birkenfeld (DE)
(74) Representative: Tegethoff, Sebastian

(57) **Abstract**

The present disclosure a homogenizer (40) which is arranged in the optical axis (A) of a light beam, comprising a housing (42) which is connected at one end for exit of the light beam to a base plate (41) and at the other end where the light beam enters the optical element through to an aspherical lens (43) arranged in an aspherical lens mount (52), the homogenizer (40) comprising a centrally arranged glass rod (45) which is arranged with its longitudinal extension in the axis (A) of the light beam, wherein the glass rod (45) is fixed with a first end in a central opening (41a) of the base plate (41) and with the opposite second end in a mount (48), wherein the mount (48) is arranged form-fitting in the housing (42) so that it can move longitudinally in the housing (42). Another object of the present disclosure relates to a system comprising a homogenizer (40) as described above and a chassis (5) into which the homogenizer (40) is mounted. Another object of the present disclosure relates to a light engine (1) comprising a homogenizer (40) as described above or a system as described above

## Description

### Field of the Disclosure

The present disclosure relates to an optical element for beam shaping.

### Brief description of the related art

Automated analyser systems for use in clinical diagnostics and life sciences are produced by a number of companies. For example, STRATEC^{®} SE, Birkenfeld, Germany, produces a number of devices for specimen handling and detection for use in automated analyser systems and other laboratory instrumentation.

Fluorescence is used for diagnostic purposes in automated analyzer systems for imaging. A light source emits light which is absorbed by a substance. Fluorescence is the result of an absorbed photon from the light source by an orbital electron in a molecule of the substance and exciting it to a higher energy level. The electron returns to its former energy level by losing energy, emitting another photon of a different frequency, which can be observed as a fluorescent glow.

Appropriate light sources are required for applications using fluorescence. Multiple wavelengths are needed which can be used separately but preferably within the same instrument. The distribution of beam angles and intensity is influenced by the optical design of a light engine and becomes more difficult with a larger number of required channels. A homogenous distribution of beam angles is to be provided to ensure homogenous illumination for different applications including darkfield setups for instance.

Thus, there is a need for a light source providing different wavelength and a homogenous irradiance of the sample plane.

### Summary of the Disclosure

The present disclosure provides an optical element which is arranged in the optical axis of a light beam, comprising a housing which is connected at an end for entry exit of the light beam to a base plate and at the end where the light beam leaves enters the optical element through to an aspherical lens arranged in an aspherical lens mount, the optical element comprising a centrally arranged glass rod which is arranged with its longitudinal extension in the axis of the light beam, wherein the glass rod is fixed with a first end in an opening of the base plate and with the opposite second end in a mount, wherein the mount is arranged form-fitting in the housing so that it can move longitudinal in the housing.

The optical element according to the present disclosure comprises in an embodiment a spring is arranged between the aspherical lens mount and a shoulder on the mount.

It is intended that the optical element comprises between the aspherical lens mount and the spring a circlip and a washer.

It is envisaged that the glass rod has a circular, rectangular or polygonal shape.

Another aspect of the optical element relates to the shape of the glass rod which tapers off from the end of the light entry exit towards the end of the light exit entry by reducing its diameter.

The mount of an optical element according to the present disclosure comprises in an embodiment for each corner of the glass rod a pocket into which each corner of the glass rod engages so that the glass rod is fixed in a manner excluding minimizing rotational and translatory movements.

It is envisaged that the base plate, housing, aspherical lens mount and mount have a cylindrical shape.

The base plate and housing are connected by a screw connection.

The mount of an optical element according to the present disclosure is in an embodiment made of plastic, and base plate, housing and aspherical lens mount are made of anodized aluminum.

Another object of the present disclosure relates to a system comprising an optical element as described above and a chassis into which the optical element is mounted.

The system comprises in an embodiment a sensor PCBA which is arranged below the aspherical lens.

It is further intended that the PCBA comprises a light sensor.

Another object of the present disclosure relates to a light engine comprising an optical element according as described above or a system according as described above.

The foregoing summary is not intended to summarize each potential embodiment or every aspect of the present disclosure.

### Summary of the Figures

The disclosure will be described based on figures. It will be understood that the embodiments and aspects of the disclosure described in the figures are only examples and do not limit the protective scope of the claims in any way. The disclosure is defined by the claims and their equivalents. It will be understood that features of one aspect or embodiment of the disclosure can be combined with a feature of a different aspect or aspects of other embodiments of the disclosure, in which:
FIG. 1 shows a perspective view onto a modular assembled light engine 1 without top cover and cooling section.
FIG. 2 shows a mounted homogenizer with aspherical lens.
FIG. 3 shows a mounted homogenizer assembly mounted to a chassis.
FIG. 4 shows in its left part mounted homogenizer 40 with indicated section plane B-B shown in the right part of FIG. 4.
FIG. 5 shows the mounting of the larger end 45b of glass rod 45 in base plate 41. The left part of FIG. 5 shows a sectional side view of mounted homogenizer45 indicating sectional plane C-C shown in the right part of FIG. 5.

### Detailed Description of the Disclosure and the Figures

The technical problem is solved by the independent claims. The dependent claims cover further specific embodiments of the disclosure.

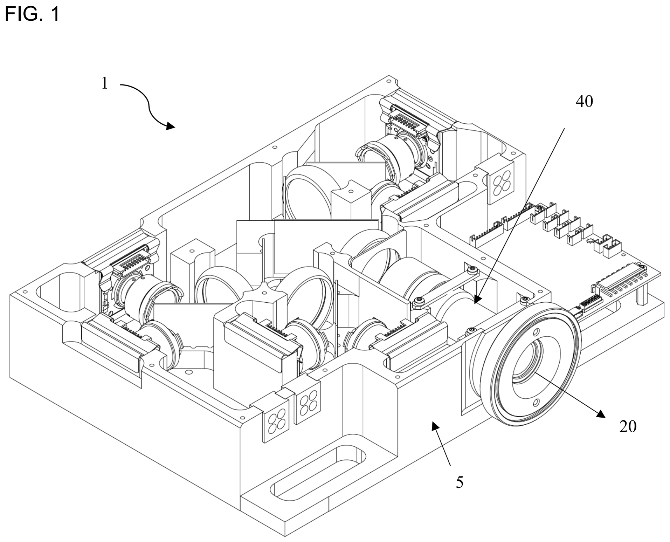

The present disclosure relates to a modular assembled light engine comprising a so-called homogenizer representing the light exit port of the light engine. FIG. 1 shows a perspective view onto a modular assembled light engine 1 without top cover comprising a mounted homogenizer40 which is arranged in such a manner in chassis 5 that it represents a light output 20 of the light engine.

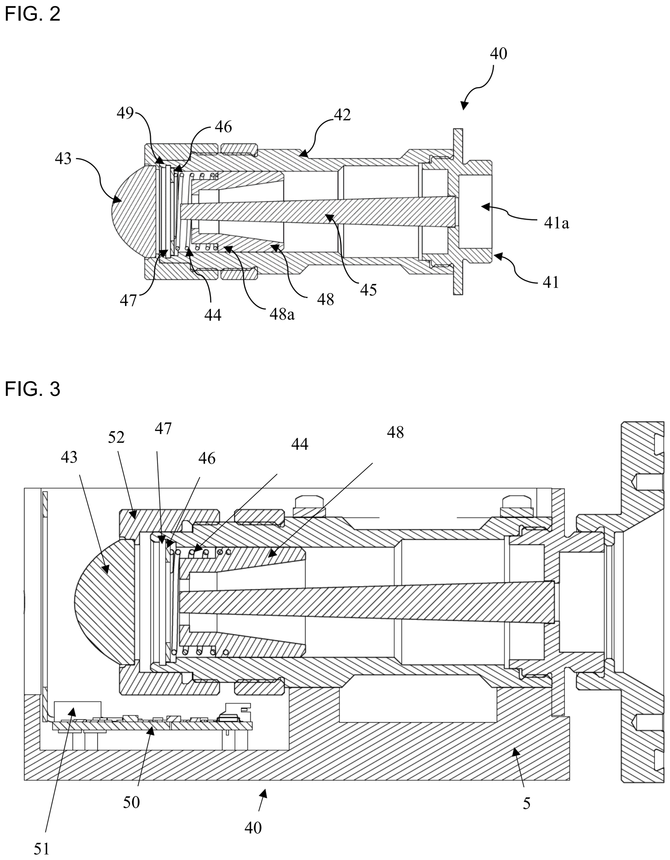

FIG. 2 shows a mounted homogenizer40 in a sectional view. The mounted homogenizer 40 has a substantially cuboid shape without being limited to that shape and comprises a base plate 41 as a light output with a central opening 41a Cylindrical housing 42 is fixed to base plate 41, for instance by a screw connection between base plate 41 and housing 42. Centrally arranged in housing 42 is a glass rod 45 for transmission of the coupled light. The glass rod 45 may have longitudinal a tapered shape so that its diameter decreases towards the light output of mounted homogenizer 40. The light is coupled into the mounted homogenizer through an aspherical lens 43.

The glass rod 45 is only fixed in the base plate 41 and in mount 48 so that the amount of decoupled light is reduced. Mount 48 is arranged form-fitting inside housing 42 and made of plastic, like polyoxymethylene for example, while base plate 41, aspherical lens mount 52 and housing 42 are preferably made of anodized aluminum. Mount 48 can move longitudinal in housing 42, for instance when glass rod 45 extends or decreases in its longitudinal length or when glass rod 45 and mount 48 extend differently due to their differing material. Such changes in length can be caused by heating or cooling of glass rod 45.

Mount 48 and housing 42 have both a cylindrical shape and mount 48 is pushed form-fitting into housing 42. The outer circumference of mount 48 corresponds to the inner circumference of housing 42 allowing mount 48 to move longitudinal in housing 42. Mount 48 is kept in place by spring 44 which is arranged between circlip 47 which is pressed at end 49 of the housing 42 and shoulder 48a of mount 48. Between spring 44 and circlip 47 is a washer 46 arranged. Light enters the mounted homogenizerb40 through lens 43 of the mounted homogenizer 40 and leaves the mounted homogenizer 40 through hole 41a in the base plate.

FIG. 3 shows mounted homogenizer 40 fixed in chassis 5. A sensor PCBA 50 is arranged below lens 43 and comprises sensor 51 for sensing excited light. The output spectrum is monitored using a color sensor or a compact spectrometer in the light engine. The homogeneity in the sample plane is monitored over the operating time.

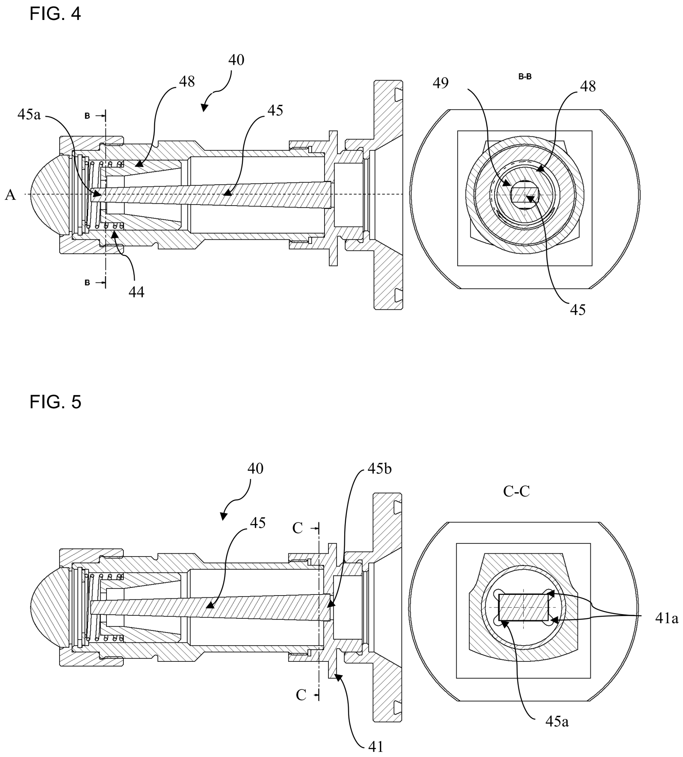

The holder of the mounted homogenizer's glass rod 45 comprises a tolerance compensation with respect to a linear (longitudinal) expansion in the direction of the optical axis. FIG. 4 shows in its left part mounted homogenizer 40 with indicated section plane B-B shown in the right part of FIG. 4. The smaller end 45a of glass rod 45 is fixed and aligned in mount 48 by fitting in a bore 49. In the event of length tolerances or thermal expansion, mount 48 moves in housing 42 parallel to the optical axis A. The pressure spring 44 ensures sufficient contact pressure in all cases so that the glass rod 45 remains fixed in place.

FIG. 5 shows the mounting of the larger end 45b of glass rod 45 in base plate 41. The left part of FIG. 5 shows a sectional side view of mounted homogenizer45 indicating sectional plane C-C shown in the right part of FIG. 5. Four pockets 41a are milled into base plate 41, each pocket 41a being shaped as a recess for receiving a corner 45a of glass rod 45. Glass rod 45 has a substantially rectangular shape, as can be taken from the right parts of FIG. 4 and FIG. 5. Thus, the glass rod 45 is arranged in base plate 41 so that rotational or translatory movements of the glass rod 45 are prevented.

The present disclosure describes a design which takes especially care of the output homogeneity, not only regarding the light power but also the outcoming ray angles, to ensure optimal homogeneity independent of the following optics.

The foregoing description of preferred and other embodiments is not intended to limit or restrict the scope or applicability of the inventive concepts conceived of by the Applicants. It will be appreciated with the benefit of the present disclosure that features described above in accordance with any embodiment or aspect of the disclosed subject matter can be utilized, either alone or in combination, with any other described feature, in any other embodiment or aspect of the disclosed subject matter.

### Reference Numerals

- 38: end cap
- 39: bore
- 40: mounted homogenizer
- 41: base plate
- 41a: pocket
- 42: housing
- 43: aspherical lens
- 44: spring
- 45: glass rod
- 45a: corner
- 46: washer
- 47: circlip
- 48: mount
- 48a: shoulder
- 49: end housing
- 50: sensor PCBA
- 51: sensor
- 52: aspheric lens mount

## Claims

1. An optical element which is arranged in the optical axis of a light beam, comprising a housing which is connected at an end for exit of the light beam to a base plate and at the end where the light beam enters the optical element to an aspherical lens arranged in an aspherical lens mount, the optical element comprising a centrally arranged glass rod which is arranged with its longitudinal extension in the axis of the light beam, wherein the glass rod is fixed with a first end in an opening of the base plate and with the opposite second end in a mount, wherein the mount is arranged form-fitting in the housing so that it can move longitudinal in the housing.

2. The optical element of claim 1, wherein a spring is arranged between the aspherical lens mount and a shoulder on the mount.

3. The optical element of claim 2, wherein between the aspherical lens mount and the spring are a circlip and a washer arranged.

4. The optical element of any one of claims 1 to 3, wherein the glass rod has a circular, rectangular or polygonal shape.

5. The optical element of any one of claims 1 to 4, wherein the shape of the glass rod tapers off from the end of the light exit towards the end of the light entry by reducing its diameter.

6. The optical element of any one of claims 1 to 5, wherein the mount comprises for each corner of the glass rod a pocket into which each corner of the glass rod engages so that the glass rod is fixed in a manner minimizing rotational and translatory movements.

7. The optical element of any one of claims 1 to 6, wherein base plate, housing, aspherical lens mount and mount have a cylindrical shape.

8. The optical element of any one of claims 1 to 7, wherein base plate and housing are connected by a screw connection.

9. The optical element of any one of claims 1 to 8, wherein the mount is made of plastic, and base plate, housing and aspherical lens mount are made of anodized aluminum.

10. A system comprising an optical element according to any one of claims 1 to 10 and a chassis into which the optical element is mounted.

11. The system of claim 10, wherein a sensor PCBA is arranged below the aspherical lens.

12. The system of any one of claims 10 or 11, wherein the PCBA comprises a light sensor.

13. A light engine comprising an optical element according to any one of claims 1 to 9 or a system according to claims 11 or 12.
